# FASCICULE DE BREVET EUROPEEN

(11) **EP 4 627 715 B1**
(45) Date de publication et mention de la délivrance du brevet: **31.12.2025**
(21) Numéro de dépôt: 25705902.2
(22) Date de dépôt: 18.02.2025
(51) Int. Cl.: H03F 1/52, H03F 3/45

(54) **DISPOSITIF AMPLIFICATEUR**
VERSTÄRKERVORRICHTUNG
AMPLIFIER DEVICE

(30) Priorité: 22.02.2024 FR 2401620
(43) Date de publication de la demande: 08.10.2025
(73) Titulaire: Airbus Defence and Space SAS, 31402 Toulouse Cedex 4 (FR)
(72) Inventeur: RUFFINONI, Pierre, 31402 Toulouse cedex 4 (FR); MORAND, Sébastien, 31402 Toulouse cedex 4 (FR); GUILLOT, Julien, 31402 Toulouse cedex 4 (FR)
(74) Mandataire: Santarelli
(86) Numéro de dépôt international: PCT/EP2025/054369
(87) Numéro de publication internationale: WO 2025/176687

(56) Documents cités:
- CN-A- 111 404 505
- CN-U- 214 591 329
- US-A1- 2021 184 634
- LI CHAOCHEN ET AL: "Low-noise amplification of voltage response for thermopile optical detectors", JOURNAL OF PHYSICS: CONFERENCE SERIES, INSTITUTE OF PHYSICS PUBLISHING, GB, vol. 2226, no. 1, 1 March 2022 (2022-03-01), XP020419635, ISSN: 1742-6588, [retrieved on 20220301], DOI: 10.1088/1742-6596/2226/1/012001

## Description

### 1. DOMAINE TECHNIQUE

Le domaine de l'invention est celui des dispositifs amplificateurs.

L'invention se rapporte plus particulièrement à un dispositif amplificateur embarqué dans un engin spatial, par exemple un satellite.

L'invention s'applique notamment, mais non exclusivement, à un correcteur proportionnel intégral (« PI ») qui comporte un dispositif amplificateur et à un convertisseur de type tension continue / tension continue, régulé.

La présente invention n'est pas limitée à cette application particulière et présente un intérêt pour toutes les applications dans lesquelles une défaillance d'un amplificateur opérationnel ou un évènement singulier (en anglais « single event ») provoquant un dysfonctionnement momentané d'un amplificateur opérationnel peuvent impacter le fonctionnement d'un circuit électronique analogique.

### 2. ARRIÈRE-PLAN TECHNOLOGIQUE

Un amplificateur opérationnel (aussi dénommé « ampli-op », « ampli op », « AOP » ou, en anglais, « op amp » ou « opamp » abréviations de « operational amplifier ») est un amplificateur différentiel à grand gain : c'est un amplificateur électronique qui amplifie fortement une différence de potentiels électriques présente à ses entrées. Le gain en tension très important d'un ampli-op en boucle ouverte fait de lui un composant utilisé dans une grande variété d'applications. Initialement, les ampli-op ont été conçus pour effectuer des opérations mathématiques dans les calculateurs analogiques. Ils permettaient d'implémenter facilement les opérations mathématiques de base telles que l'addition, la soustraction, l'intégration, la dérivation. Par la suite, l'amplificateur opérationnel a été utilisé dans bien d'autres applications, telles que la commande de moteurs, la régulation de tension, les sources de courants ou les oscillateurs.

Physiquement, un amplificateur opérationnel est constitué de transistors, communément sous la forme d'un circuit intégré.

La popularité de l'amplificateur opérationnel comme composant des circuits analogiques est due à sa polyvalence. En utilisant une rétroaction négative, les caractéristiques d'un circuit d'ampli-op, son gain, son impédance d'entrée et de sortie, sa largeur de bande, etc., sont déterminées par des composants externes et dépendent peu des coefficients de température ou de la tolérance technique de l'ampli-op lui-même.

Les ampli-op sont maintenant très utilisés dans les appareils électroniques, y compris dans une vaste gamme d'appareils grand public, industriels et scientifiques et de véhicules terrestres. De nombreux circuits intégrés d'ampli-op standards, c'est-à-dire fabriqués en série et non sur commande (désignés sous le nom anglais de « commercial off the shelf » ou « COTS », que l'on peut traduire par commercial sur étagère) ne coûtent que quelques centimes. Inversement, certains ampli-op intégrés ou hybrides, avec des spécifications de performance spéciales (désignés composant High Reliability ou « Hi-Rel », que l'on peut traduire par haute fiabilité), peuvent coûter plus d'une centaine de dollars américains en petites quantités.

Les ampli-op peuvent être utilisés comme composants ou comme éléments de circuits intégrés plus complexes ou soumis à des contraintes spécifiques. Dans le domaine spatial, « NewSpace » est un terme lié à l'émergence d'une industrie spatiale d'initiative privée. Ils concernent plus particulièrement le développement d'un accès à bas coût (« low-cost ») et public au domaine spatial.

Avec l'avènement de cette industrie, notamment pour le déploiement de constellations de satellites, de nouveaux composants conçus pour le secteur automobile ont été introduits dans les engins spatiaux. Par rapport aux composants durcis contre les radiations (en anglais « radiation hardened »), ces composants ont l'avantage d'être beaucoup moins chers, plus compacts et plus performants. En revanche, comme la plupart des dispositifs électroniques à semiconducteur, ces composants, et notamment les amplificateurs opérationnels, sont sensibles aux effets d'événement singuliers (ou « SEE », acronyme de « Single Event Effect »). Dans l'espace, lorsque des particules telles que des ions lourds (provenant de l'environnement radiatif naturel) frappent certaines zones du circuit intégré, son comportement peut être perturbé pendant une certaine durée. Ainsi, les amplificateurs opérationnels présentent une vulnérabilité très contraignante qui nécessite de complexifier le dimensionnement des circuits électroniques des engins spatiaux.

L'usage des amplificateurs opérationnels dans ce contexte est donc devenu très complexe et des alternatives onéreuses ont été mises en place pour se passer de ce composant, alors qu'ils étaient auparavant très utilisés dans les électroniques spatiales grâce à sa polyvalence. Par exemple, les alternatives pour réduire les signatures SEE d'un circuit électronique opérationnel comportent :
- soit d'utiliser d'autres composants, comme des FPGA (« Field-programmable gate array », ce qui peut être traduit en français par « réseau de portes programmables sur site ») ou des comparateurs, par exemple pour faire une régulation de convertisseurs de type tension continue / tension continue (communément notés « DC/DC »),
- soit d'accepter de subir le SEE de l'amplificateur opérationnel en désoptimisant toute l'architecture électronique, par exemple par ajout de filtres passe-bas, ajout de post-régulateurs, etc.

Chacune de ces alternatives impose une complexité et un surcoût important des circuits électroniques.

Le document « Low-noise amplification of voltage response for thermopile optical detectors », Li Chaochen et al., divulgue un dispositif d'amplification d'un signal de faible amplitude dans une thermopile, visant à réduire le bruit lors de l'amplification.

La demande de brevet US2021/184634A1 divulgue un dispositif d'amplification d'un signal de faible amplitude dans un photosenseur, visant à obtenir des performances de détection robustes même en présence de déséquilibres entre les amplificateurs.

Le modèle d'utilité CN214591329U divulgue un dispositif permettant de réduire le bruit d'un préamplificateur.

La demande de brevet CN111404505A divulgue un dispositif amplificateur de tension pour un détecteur de plasma spatial à basse énergie. Le dispositif amplificateur de tension comprend un circuit de commande d'amplificateur, un circuit de commande d'optocoupleur et un dispositif d'optocoupleur haute tension qui sont connectés en séquence. Un circuit d'échantillonnage de tension est connecté au circuit de commande d'optocoupleur et aux dispositifs d'optocoupleur haute tension.

### 3. RÉSUMÉ

La présente invention vise à remédier à tout ou partie des inconvénients de l'art antérieur.

À cet effet, selon un premier aspect, la présente invention vise un correcteur proportionnel intégral selon la revendication indépendante 1.

En comportant une pluralité d'amplificateurs opérationnels montés en parallèle et qui amplifient les mêmes signaux, puis en constituant la moyenne des signaux amplifiés le dispositif amplificateur fournit un signal amplifié moins sensible aux défaillances et SEE que les amplificateurs opérationnels utilisés. D'un point de vue utilisateur, ce dispositif amplificateur se comporte comme un macro-composant classique qui ne subit en sortie, lors de SEE, que de petites variations d'une microseconde environ et d'amplitude égale à un n^{ième} de leur tension d'alimentation.

Le dispositif amplificateur objet de l'invention permet de réduire drastiquement la signature SEE par rapport à l'un des n amplificateurs opérationnels incorporés dans le dispositif. L'invention permet ainsi de réhabiliter l'amplificateur opérationnel dans les électroniques d'engins spatiaux en proposant un montage peu encombrant et de faible coût.

Ce dispositif amplificateur permet de réaliser une fonction amplificateur opérationnel compatible avec les spécifications spatiales et compétitive en termes de coût et en termes de compacité. Ce dispositif amplificateur possède une forte tolérance aux effets singuliers de l'environnement naturel, notamment en diminuant la durée résiduelle des perturbations et leur occurrence, ce qui permet leur utilisation dans des applications spatiales.

Cela permet de réduire fortement les contraintes relatives à l'environnement spatial sur les conceptions d'électroniques analogiques, par exemple de chaînes d'acquisition, d'électroniques de puissance, de convertisseurs et de régulateurs linéaires. Ces conceptions se trouvent ainsi plus simples, plus compactes et plus robustes.

Dans des modes de réalisation, le dispositif amplificateur comporte, pour chaque amplificateur opérationnel, un circuit de découplage indépendant, entre l'entrée de tension d'alimentation positive V_{CC} et la borne d'alimentation positive de cet amplificateur opérationnel.

En découplant chacune des entrées des amplificateurs opérationnels, on améliore encore les performances du dispositif amplificateur.

Dans des modes de réalisation, le circuit de découplage indépendant de chaque amplificateur opérationnel comporte :
- au moins une résistance électrique entre l'entrée de tension d'alimentation positive V_{CC} et la borne d'alimentation positive de cet amplificateur opérationnel et
- au moins un condensateur entre l'entrée de tension d'alimentation négative V_{EE} et la borne d'alimentation positive de cet amplificateur opérationnel.

Ce circuit de découplage est simple, compact et robuste.

Dans des modes de réalisation, pour chaque amplificateur opérationnel :
- la borne non inverseuse d'entrée de signal Viₚₗᵤₛ est reliée à l'entrée de signal Vₚₗᵤₛ, par l'intermédiaire d'au moins une résistance électrique identique pour les n amplificateurs opérationnels, et
- la borne inverseuse d'entrée de signal Viₘₒᵢₙₛ est reliée à l'entrée de signal Vₘₒᵢₙₛ, par l'intermédiaire d'au moins une résistance électrique identique pour les n amplificateurs opérationnels.

Ce montage en parallèle des n amplificateurs opérationnels avec des résistances respectivement identiques pour leurs entrées de signaux à amplifier assure que les signaux Viₚₗᵤₛ sont identiques pour les n amplificateurs opérationnels, et que les signaux Viₘₒᵢₙₛ sont identiques pour les n amplificateurs opérationnels.

Dans des modes de réalisation, le module électronique de constitution de la moyenne des tensions de sortie amplifiées Viₒᵤₜ des amplificateurs opérationnels comporte, entre chaque borne de sortie de tension amplifiée Viₒᵤₜ d'un amplificateur opérationnel et la sortie de tension amplifiée, au moins une résistance électrique.

La moyenne est ainsi réalisée avec des composants extrêmement simples, légers et peu encombrants.

Dans des modes de réalisation, le dispositif amplificateur objet de l'invention comporte, dans un circuit intégré unique :
- les n amplificateurs opérationnels,
- les n boucles fermées de contrôle de dynamique reliant la borne Viₒᵤₜ à la borne d'entrée de la tension Vₘₒᵢₙₛ d'un amplificateur opérationnel, et
- le module électronique de constitution de la moyenne des tensions de sortie amplifiées Viₒᵤₜ des n amplificateurs opérationnels.

Ainsi la mise en œuvre du dispositif amplificateur objet de l'invention peut prendre la forme d'un simple circuit intégré, comme un simple amplificateur opérationnel. Une éventuelle boucle de rétroaction est alors réalisée à l'extérieur de ce circuit intégré.

La présente invention vise un correcteur proportionnel intégral, qui comporte un dispositif amplificateur tel que succinctement exposé ci-dessus et une boucle fermée de rétroaction négative reliant la sortie Vₒᵤₜ à l'entrée Vₘₒᵢₙₛ, comportant en série, au moins un condensateur et au moins une résistance électrique ;
- l'entrée Vₘₒᵢₙₛ recevant un signal électrique par l'intermédiaire d'au moins une résistance électrique
- l'entrée Vₚₗᵤₛ recevant un signal électrique par l'intermédiaire d'au moins une résistance électrique.

Selon un deuxième aspect, la présente invention vise un convertisseur de type tension continue / tension continue, régulé, qui comporte un correcteur proportionnel intégral objet de l'invention, dans lequel la boucle fermée de rétroaction négative reliant la sortie Vₒᵤₜ à l'entrée Vₘₒᵢₙₛ comporte, en série, au moins une résistance électrique et au moins un condensateur.

Les avantages, buts et caractéristiques particulières de ce correcteur proportionnel intégral et de ce convertisseur étant similaires à ceux du dispositif objet de l'invention, ils ne sont pas rappelés ici.

Selon un troisième aspect, la présente invention vise un équipement spatial comportant au moins un convertisseur de type tension continue / tension continue régulé objet de l'invention.

### 4. LISTE DES FIGURES

D'autres buts, caractéristiques et avantages de l'invention apparaîtront à la lecture de la description suivante, donnée à titre d'exemple illustratif et non limitatif, en relation avec les dessins annexés, dans lesquels :
[Fig. 1] représente un schéma électronique d'un mode de réalisation particulier du dispositif amplificateur objet de l'invention comportant quatre amplificateurs opérationnels ;
[Fig. 2] représente un schéma électronique de circuits de découplage indépendants des quatre amplificateurs opérationnels du dispositif illustré en [Fig. 1] ;
[Fig. 3] représente un schéma bloc comportant les composants illustrés en [Fig. 1] et en [Fig. 2] ;
[Fig. 4] représente un schéma électronique d'un correcteur proportionnel intégral comportant le circuit intégré illustré en [Fig. 3] ;
[Fig. 5] représente un résultat de simulation de la réponse du correcteur proportionnel intégral de la [Fig. 4] aux effets d'un événement singulier sur l'un des amplificateurs opérationnels,
[Fig. 6] représente un schéma bloc d'un convertisseur buck ; et
[Fig. 7] représente un équipement spatial comportant un convertisseur buck régulé illustré en [Fig. 6].

### 5. DESCRIPTION DÉTAILLÉE

Sur toutes les figures du présent document, les éléments et étapes identiques sont désignés par une même référence numérique.

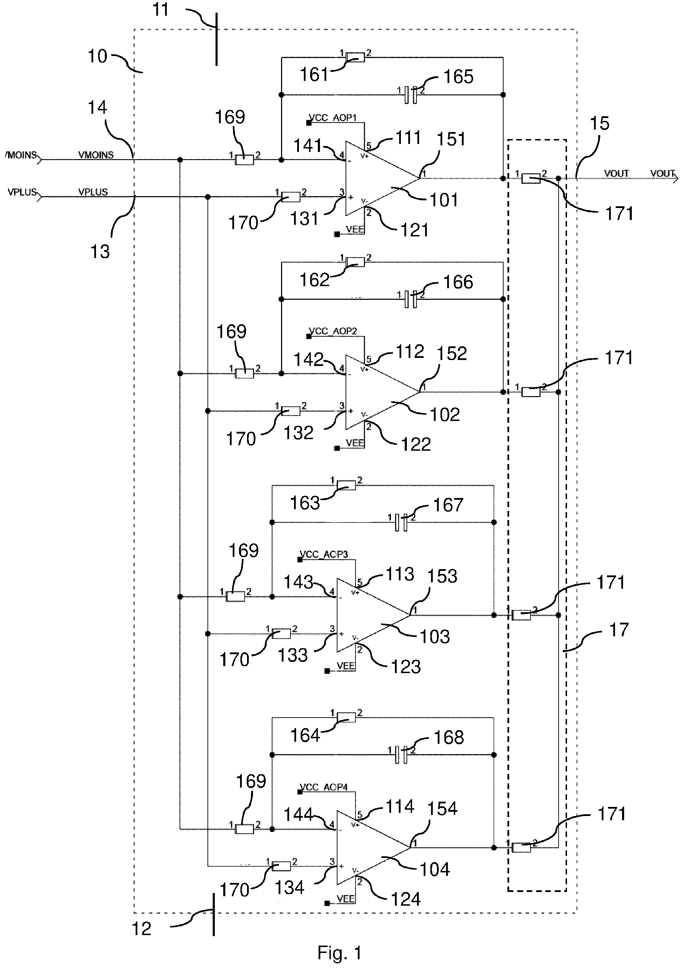

On observe, en [Fig. 1], un dispositif amplificateur 10 comprenant :
- une entrée 11 de tension d'alimentation positive, tension appelée « V_{CC} »,
- une entrée 12 de tension d'alimentation négative ou « de référence », tension appelée « V_{EE} »,
- une entrée non inverseuse 13 de signal, appelée « Vₚₗᵤₛ », ce signal ayant une tension comprise entre les tensions d'alimentation V_{CC} et V_{EE},
- une entrée inverseuse 14 de signal, appelée « Vₘₒᵢₙₛ », ce signal ayant une tension comprise entre les tensions d'alimentation V_{CC} et V_{EE},
- une sortie 15 de signal amplifié, appelée « Vₒᵤₜ ».

Le dispositif amplificateur 10 comporte, de plus, un nombre entier n, strictement supérieur à 1, d'amplificateurs opérationnels. Le nombre n est déterminé selon des critères d'optimisation tenant compte, par exemple de l'encombrement, du poids, de la consommation électrique, du prix de revient et de la vulnérabilité à l'environnement radiatif naturel.

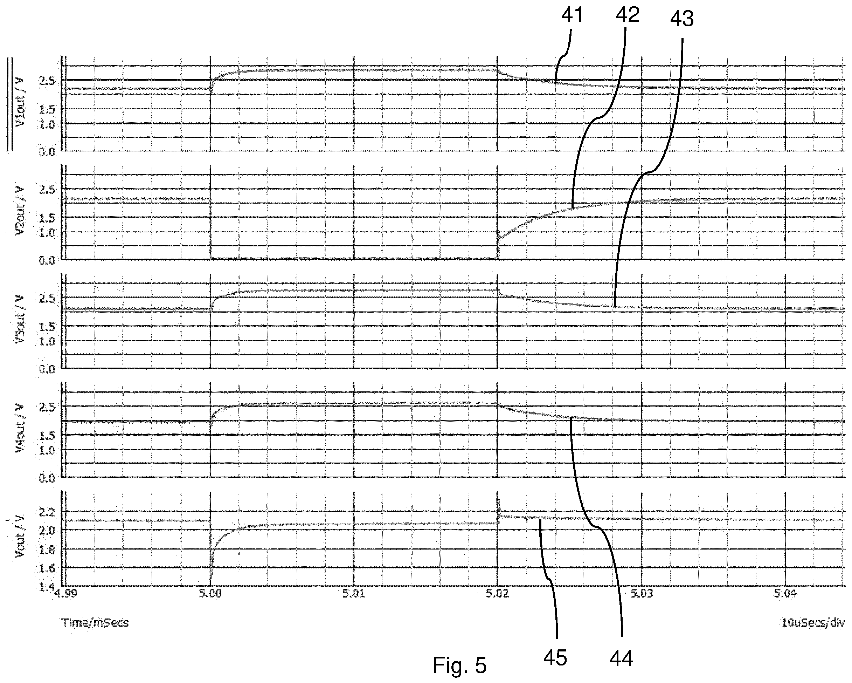

En [Fig. 1] et [Fig. 5], le nombre n est égal à quatre. Il y a donc quatre amplificateurs opérationnels identiques 101 à 104. Chaque amplificateur opérationnel i, avec i entre 1 et 4 compris, possède :
- une borne d'alimentation positive, respectivement 111 à 114, reliée à l'entrée11 de tension d'alimentation positive V_{CC},
- une borne d'alimentation négative, respectivement 121 à 124, reliée à l'entrée 12 de tension d'alimentation négative V_{EE},
- une borne non inverseuse d'entrée de signal, appelée Viₚₗᵤₛ, respectivement 131 à 134, reliée à l'entrée 13 de signal Vₚₗᵤₛ, de telle manière que les signaux Viₚₗᵤₛ sont identiques pour les n amplificateurs opérationnels,
- une borne inverseuse d'entrée de signal, appelée Viₘₒᵢₙₛ, respectivement 141 à 144, reliée à l'entrée 14 de signal Vₘₒᵢₙₛ, de telle manière que les signaux Viₘₒᵢₙₛ sont identiques pour les n amplificateurs opérationnels,
- une borne de sortie de signal amplifié, appelé Viₒᵤₜ, respectivement 151 à 154, de tension comprise entre les tensions d'alimentation V_{CC} et V_{EE}, résultant de l'amplification de la différence des deux tensions des signaux d'entrée Viₚₗᵤₛ et Viₘₒᵢₙₛ selon un gain prédéterminé identique pour les n amplificateurs opérationnels, et
- une boucle fermée de contrôle de dynamique reliant la borne Viₒᵤₜ, respectivement 151 à 154, à la borne d'entrée de signal Viₘₒᵢₙₛ, respectivement 141 à 144, est constituée d'au moins une résistance électrique, respectivement 161 à 164 et au moins un condensateur, respectivement 165 à 168, montés en parallèle.

Le dispositif amplificateur 10 comporte aussi un module électronique 17 de constitution de la moyenne des tensions des signaux de sortie amplifiés Viₒᵤₜ, respectivement 151 à 154, des n amplificateurs opérationnels 111 à 114, pour générer le signal amplifié Vₒᵤₜ sur la sortie de signal amplifié 15.

Chacune des résistances identiques 169, positionnée entre l'entrée 14 et l'une des entrées 141 à 144 de l'un des amplificateurs opérationnels 101 à 104, d'une part, et chacune des résistances identiques 170, positionnée entre l'entrée 13 et l'une des entrées 131 à 134 de l'un des amplificateurs opérationnels 101 à 104, d'autre part, assurent que :
- les signaux Viₚₗᵤₛ sont, aux disparités près liées aux tolérances de fabrications des composants, identiques pour les n (quatre dans l'exemple représenté) amplificateurs opérationnels 101 à 104,
- les signaux Viₘₒᵢₙₛ sont, aux disparités près liées aux tolérances de fabrications des composants, identiques pour les n amplificateurs opérationnels 101 à 104. Ainsi, pour chaque amplificateur opérationnel 101 à 104 :
- la borne non inverseuse 131 à 134 d'entrée de signal Viₚₗᵤₛ est reliée à l'entrée 13 de signal Vₚₗᵤₛ, par l'intermédiaire d'au moins une résistance électrique 170 identique pour les n amplificateurs opérationnels 101 à 104, et
- la borne inverseuse 141 à 144 d'entrée de signal Viₘₒᵢₙₛ est reliée à l'entrée 14 de signal Vₘₒᵢₙₛ, par l'intermédiaire d'au moins une résistance électrique 169 identique pour les n amplificateurs opérationnels 101 à 104.

Ce montage en parallèle des n amplificateurs opérationnels 101 à 104 avec des résistances 169 et 170, respectivement identiques pour leurs entrées de signaux à amplifier Viₚₗᵤₛ et Viₘₒᵢₙₛ assurent que les signaux Viₚₗᵤₛ sont, aux disparités près liées aux tolérances de fabrications des composants, identiques pour les n amplificateurs opérationnels, et que les signaux Viₘₒᵢₙₛ sont, aux disparités près liées aux tolérances de fabrications des composants, identiques pour les n amplificateurs opérationnels. On note que la valeur des résistances 169 et celle des résistances 170 peuvent être différentes.

Le module électronique 17 de constitution de la moyenne des tensions des signaux de sortie sur les sorties 151 à 154 des amplificateurs opérationnels 101 à 104 comporte quatre résistances identiques 171 reliées, d'une part, à ces sorties 151 à 154 et, d'autre part, à la sortie 15.

Comme on le comprend à la lecture de la description qui précède, les amplificateurs opérationnels 101 à 104 reçoivent les mêmes signaux Viₚₗᵤₛ et Viₘₒᵢₙₛ et amplifient leur différence avec le même gain. La moyenne des signaux de sortie Viₒᵤₜ permet que, même si l'un des amplificateurs opérationnels 101 à 104 subit un événement singulier, le signal de sortie moyenné Viₒᵤₜ présente une variation inférieure à un n^{ième} de la différence entre les tensions d'alimentation positive V_{CC} et négative V_{EE}.

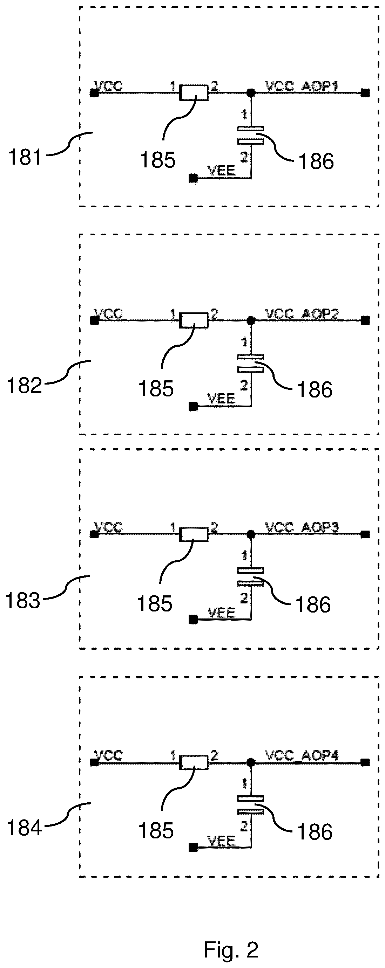

On observe, en [Fig. 2], quatre circuits de découplage indépendants 181 à 184 des quatre amplificateurs opérationnels, respectivement 101 à 104. Chaque circuit de découplage indépendant 181 à 184 est positionné entre l'entrée de tension d'alimentation positive V_{CC} 11 du dispositif amplificateur 10 et la borne d'alimentation positive 111 à 114 de l'un des amplificateurs opérationnels 101 à 104. Dans le mode de réalisation représenté en [Fig. 2], chaque circuit de découplage indépendant 181 à 184 de chaque amplificateur opérationnel 101 à 104 comporte :
- au moins une résistance électrique 185 entre l'entrée de tension d'alimentation positive V_{CC} 11 et la borne d'alimentation positive 111 à 114 de cet amplificateur opérationnel 101 à 104 et
- au moins un condensateur 186 entre l'entrée de tension d'alimentation négative V_{EE} 12 et la borne d'alimentation positive 111 à 114 de cet amplificateur opérationnel 101 à 104.

En découplant chacune des entrées des amplificateurs opérationnels 101 à 104, on améliore encore les performances du dispositif amplificateur 10.

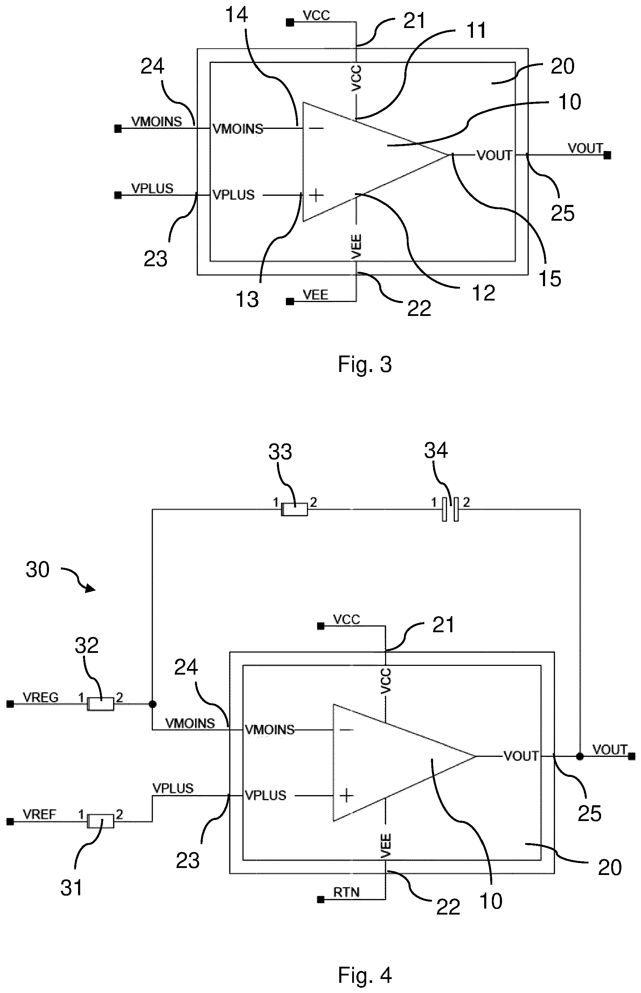

On observe, en [Fig. 3], un schéma bloc 20 comportant les composants du dispositif amplificateur 10, lui-même représenté comme un amplificateur opérationnel. Dans ce circuit intégré 20, une broche 21 est électriquement reliée à l'entrée 11 de tension d'alimentation positive V_{CC}, une broche 22 est électriquement reliée à l'entrée 12 de tension d'alimentation négative V_{EE}, une broche 23 est électriquement reliée à l'entrée non inverseuse 13 de signal Vₚₗᵤₛ, une broche 24 est électriquement reliée à l'entrée inverseuse 14 de signal Vₘₒᵢₙₛ, et une broche 25 est reliée à la sortie 15 de signal amplifié Vₒᵤₜ.

### 6. EXEMPLES DE MISE EN ŒUVRE DE L'INVENTION

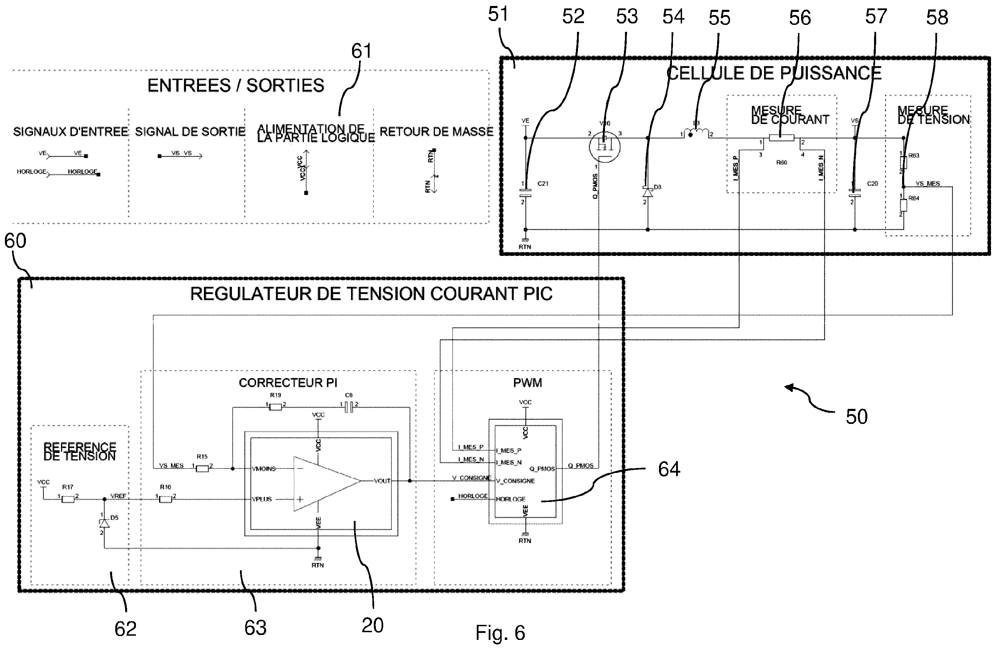

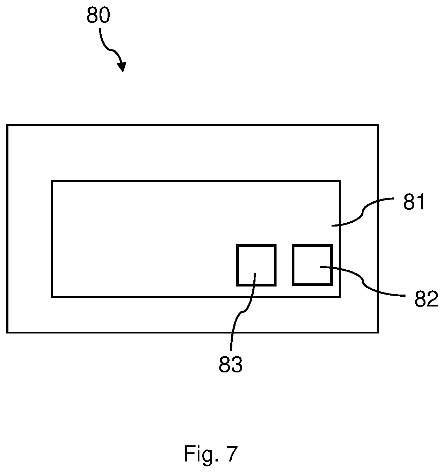

On présente désormais, en relation avec la [Fig. 4], la [Fig. 6] et la [Fig. 7] des exemples de mise en œuvre du dispositif amplificateur objet de l'invention dans des circuits électroniques analogiques.

On observe, en [Fig. 4], un schéma électronique d'un correcteur proportionnel intégral 30 comportant le circuit intégré 20. Pour constituer ce correcteur proportionnel intégral, on associe au circuit intégré 20, deux résistances externes 31 et 32 en entrée des signaux sur les broches 23 et 24 du circuit intégré 20. De plus, on associe au circuit intégré 20, une boucle de rétroaction formée d'une résistance 33 et d'un condensateur 34, montés en série entre la sortie 25 et l'entrée 24, en aval de la résistance 32. On note, dans le schéma de la [Fig. 4], que la broche 22 est reliée à un nœud de retour de masse (le « 0 » de tension). Ainsi, dans ce montage, V_{EE} n'est pas une tension négative mais la tension nulle.

On observe, en [Fig. 5], une simulation corroborée par des résultats expérimentaux de la réponse du correcteur proportionnel intégral 30 aux effets d'un événement singulier affectant l'amplificateur opérationnel 102. Dans cette [Fig. 5], la courbe 41 représente la réponse de l'amplificateur opérationnel 101, la courbe 42 représente la réponse de l'amplificateur opérationnel 102, la courbe 43 représente la réponse de l'amplificateur opérationnel 103, la courbe 44 représente la réponse de l'amplificateur opérationnel 104 et la courbe 45 représente la réponse du correcteur proportionnel intégral 30. Dans cet exemple, n vaut 4, V_{CC} vaut 3,3 V et V_{EE} vaut 0 V.

Un événement singulier transitoire se propage, avec pour signature une durée de 20 µs et une amplitude de 2,2V faisant passer la tension de sortie V₂ₒᵤₜ de l'amplificateur opérationnel 102 à 0 V. En réponse à ce transitoire, les trois autres amplificateurs opérationnels, non affectés par cet évènement singulier, viennent compenser cette perte de tension, filtrant pour ainsi dire la perturbation. Le résultat sur la sortie Vₒᵤₜ 45 est le suivant : on observe deux transitoires correspondant aux fronts descendants et montants de la perturbation sur V2ₒᵤₜ, le premier d'une durée d'environ 1,5 µs (maîtrisé par les éléments 169, 161 et 165) et d'amplitude de 0,6 V (inférieure à 3,3 V divisé par n, soit dans l'exemple, n = 4), le nombre n étant le nombre de contributeur à la moyenne 171, le second d'à peine 1 µs et 0.3 V.

On note donc deux résultats favorables de la mise en œuvre de la présente invention. D'une part l'amplitude des transitoires est inférieure à l'amplitude entre V_{EE} et V_{CC} divisée par le nombre n d'ampli-op. D'autre part, la durée du phénomène transitoire sur la sortie moyennée 45 est très inférieure à la durée de l'évènement singulier transitoire de la sortie 42.

On observe, en [Fig. 6], un schéma électronique d'un convertisseur buck 50, ou hacheur série. Le convertisseur buck est une alimentation à découpage qui convertit une tension continue en une autre tension continue de plus faible valeur. Il possède un fort rendement (jusqu'à 95 %) et sa tension de sortie est régulée par ajustement de la valeur du courant pic de l'inductance via la commande du rapport cyclique du transistor de puissance. Ce type de régulation est très usuel car il permet une réponse amortie aux transitoires de charges et une protection contre la saturation de l'inductance.

Ce convertisseur 50 peut se décrire en deux parties distinctes. La première est la cellule de puissance 51 du convertisseur buck 50, dont l'objet est de transférer la puissance à partir d'une commande donnée. Ce circuit 51 est composé :
- d'un condensateur 52 en entrée chargé à la tension d'entrée V_{E},
- d'un transistor de puissance commandable de type MOSFET canal P 53,
- d'une diode de type Schottky 54,
- d'une inductance 55,
- d'une résistance de type shunt 56 permettant de mesurer le courant traversant l'inductance,
- d'un condensateur 57 en sortie, chargé à la tension de sortie V_{S}, et
- d'un pont de résistance 58 permettant de mesurer la tension de sortie.

La seconde partie du convertisseur 50 est le régulateur de tension courant pic 60, dont l'objet est de fournir à la cellule de puissance 51 une commande du transistor de puissance 53 à partir des observables de tensions et de courant. Les circuits logiques sont alimentés par une source de tension V_{CC} 61. Ce circuit 60 est composé :
- d'une référence de tension 62 ;
- d'un correcteur Proportionnel Intégral (PI) 63 où l'on retrouve le composant 20 décrit en regard de la [Fig. 3]. Ce correcteur 63 fournit une valeur de consigne du courant pic permettant de réduire à zéro l'erreur entre la référence de tension 62 et la mesure de tension fournie par le pont de résistances 58 ;
- d'un module PWM 64 (en anglais « Pulse Width Modulation », en français Modulation à Largeur d'Impulsion) dont le fonctionnement nominal est le suivant.

Sur le front montant de l'horloge, une commande est envoyée pour saturer le transistor de puissance 53, et cela tant que la mesure de courant est inférieure à la tension de consigne. Lorsque la mesure de courant est supérieure à la tension de consigne, une commande est envoyée pour bloquer le transistor de puissance 53 jusqu'à un nouveau front montant de l'horloge. Et ainsi de suite pour chaque période.

Toute chose égale par ailleurs, étant donnée sa signature SET très réduite (comme décrit en regard de la [Fig. 5]), le montage 20 permet de fortement réduire les contraintes de dimensionnement de la cellule de puissance 51. En effet, la perturbation de la consigne de courant pic étant très réduite, voire insignifiante, devant la bande passante du convertisseur 50, le SET n'est plus dimensionnant pour les passifs (inductance et condensateurs de sortie) et permet une réduction de la taille des composants et donc de gagner en surface, masse et compétitivité.

Comme illustré en [Fig. 7], dans une mise en œuvre de l'invention, un équipement spatial 80 comporte un circuit électronique analogique 81 comportant une alimentation électrique 82 et un convertisseur buck 83.

## Revendications

1. Correcteur proportionnel intégral (30) comportant un dispositif amplificateur (10), ledit dispositif amplificateur (10) comprenant :
- une entrée (11) de tension d'alimentation positive, tension appelée « V_{CC} »,
- une entrée (12) de tension d'alimentation négative ou « de référence », tension appelée « V_{EE} »,
- une entrée non inverseuse (13) de signal, appelée « Vₚₗᵤₛ », ce signal ayant une tension comprise entre les tensions d'alimentation V_{CC} et V_{EE},
- une entrée inverseuse (14) de signal, appelée « Vₘₒᵢₙₛ », ce signal ayant une tension comprise entre les tensions d'alimentation V_{CC} et V_{EE},
- une sortie (15) de signal amplifié, appelée « Vₒᵤₜ » ,
- un nombre entier n, strictement supérieur à 1, d'amplificateurs opérationnels (101 à 104), chaque amplificateur opérationnel i, avec i entre 1 et n compris, possédant :
o une borne d'alimentation positive (111 à 114) reliée à l'entrée (11) de tension d'alimentation positive V_{CC},
o une borne d'alimentation négative (121 à 124) reliée à l'entrée (12) de tension d'alimentation négative V_{EE},
o une borne non inverseuse d'entrée de signal, appelée Viₚₗᵤₛ (131 à 134) reliée à l'entrée (13) de signal Vₚₗᵤₛ, de telle manière que les signaux Viₚₗᵤₛ sont identiques pour les n amplificateurs opérationnels,
o une borne inverseuse d'entrée de signal, appelée Viₘₒᵢₙₛ (141 à 144) reliée à l'entrée (14) de signal Vₘₒᵢₙₛ, de telle manière que les signaux Viₘₒᵢₙₛ sont identiques pour les n amplificateurs opérationnels,
o une borne de sortie de signal amplifié, appelée Viₒᵤₜ (151 à 154) de tension comprise entre les tensions d'alimentation V_{CC} et V_{EE}, résultant de l'amplification de la différence des deux tensions des signaux d'entrée Viₚₗᵤₛ et Viₘₒᵢₙₛ selon un gain prédéterminé identique pour les n amplificateurs opérationnels, et
o une boucle fermée de contrôle de dynamique reliant la borne Viₒᵤₜ (151 à 154) à la borne d'entrée de signal Viₘₒᵢₙₛ (141 à 144), boucle constituée d'au moins une résistance électrique (161 à 164) et au moins un condensateur (165 à 168), montés en parallèle ; et
- un module électronique (17) de constitution de la moyenne des tensions des signaux de sortie amplifiés Viₒᵤₜ (151 à 154) des n amplificateurs opérationnels (111 à 114), pour générer le signal amplifié Vₒᵤₜ sur la sortie de signal amplifiée (15) ;
le correcteur proportionnel intégral (30) comportant également une boucle fermée (33, 34) de rétroaction négative reliant la sortie Vₒᵤₜ (15) à l'entrée Vₘₒᵢₙₛ (14) et comportant en série, au moins un condensateur (34) et au moins une résistance électrique (33) ; l'entrée Vₘₒᵢₙₛ recevant un signal électrique par l'intermédiaire d'au moins une résistance électrique (32), et l'entrée Vₚₗᵤₛ (13) recevant un signal électrique par l'intermédiaire d'au moins une résistance électrique (31).

2. Correcteur proportionnel intégral (30) selon la revendication 1, qui comporte, pour chaque amplificateur opérationnel (101 à 104), un circuit de découplage indépendant (181 à 184), entre l'entrée de tension d'alimentation positive V_{CC} (11) et la borne d'alimentation positive (111 à 114) de cet amplificateur opérationnel.

3. Correcteur proportionnel intégral (30) selon la revendication 2, dans lequel le circuit de découplage indépendant (181 à 184) de chaque amplificateur opérationnel (101 à 104) comporte :
- au moins une résistance électrique (185) entre l'entrée de tension d'alimentation positive V_{CC} (11) et la borne d'alimentation positive (111 à 114) de cet amplificateur opérationnel et
- au moins un condensateur (186) entre l'entrée de tension d'alimentation négative V_{EE} (12) et la borne d'alimentation positive (111 à 114) de cet amplificateur opérationnel.

4. Correcteur proportionnel intégral (30) selon l'une des revendications 1 à 3, dans lequel, pour chaque amplificateur opérationnel (101 à 104) :
- la borne non inverseuse (131 à 134) d'entrée de signal Viₚₗᵤₛ est reliée à l'entrée (13) de signal Vₚₗᵤₛ, par l'intermédiaire d'au moins une résistance électrique (170) identique pour les n amplificateurs opérationnels, et
- la borne inverseuse (141 à 144) d'entrée de signal Viₘₒᵢₙₛ est reliée à l'entrée (14) de signal Vₘₒᵢₙₛ, par l'intermédiaire d'au moins une résistance électrique (169) identique pour les n amplificateurs opérationnels.

5. Correcteur proportionnel intégral (30) selon l'une des revendications 1 à 4, dans lequel le module électronique (17) de constitution de la moyenne des tensions de sortie amplifiées Viₒᵤₜ des amplificateurs opérationnels comporte, entre chaque borne de sortie de tension amplifiée Viₒᵤₜ (151 à 154) d'un amplificateur opérationnel (101 à 104) et la sortie de tension amplifiée (15), au moins une résistance électrique (171).

6. Correcteur proportionnel intégral (30) selon l'une des revendications 1 à 5, qui comporte, dans un circuit intégré unique (20) :
- les n amplificateurs opérationnels (101 à 104),
- les n boucles fermées (161 à 168) de contrôle de dynamique reliant la borne Viₒᵤₜ (151 à 154) à la borne d'entrée de la tension Vₘₒᵢₙₛ (141 à 144) d'un amplificateur opérationnel, et
- le module électronique (17) de constitution de la moyenne des tensions de sortie amplifiées Viₒᵤₜ des n amplificateurs opérationnels.

7. Convertisseur (50, 60) de type tension continue / tension continue, régulé, qui comporte un correcteur proportionnel intégral (30) selon l'une des revendications 1 à 6, dans lequel la boucle fermée (33, 34) de rétroaction négative reliant la sortie Vₒᵤₜ (15) à l'entrée Vₘₒᵢₙₛ (14) comporte, en série, au moins une résistance électrique (33) et au moins un condensateur (34).

8. Equipement spatial (80) comportant au moins un convertisseur (50, 60) de type tension continue / tension continue régulé selon la revendication 7.

## Patentansprüche

1. Proportional-Integral-Regler (30), eine Verstärkervorrichtung (10) enthaltend, wobei die Verstärkervorrichtung (10) umfasst:
- einen Eingang (11) für positive Versorgungsspannung, wobei diese Spannung "V_{CC}" genannt wird,
- einen Eingang (12) für negative oder "Referenz"-Versorgungsspannung, wobei diese Spannung "V_{EE}" genannt wird,
- einen nicht invertierenden Signaleingang (13), "Vₚₗᵤₛ" genannt, wobei dieses Signal eine Spannung zwischen den Versorgungsspannungen V_{CC} und V_{EE} hat,
- einen invertierenden Signaleingang (14), "Vₘᵢₙᵤₛ" genannt, wobei dieses Signal eine Spannung zwischen den Versorgungsspannungen V_{CC} und V_{EE} hat,
- einen Ausgang des verstärkten Signals (15), "Vₒᵤₜ" genannt,
- eine ganze Anzahl n, streng größer als 1, von Betriebsverstärkern (101 bis 104), wobei jeder Betriebsverstärker i, wobei i zwischen 1 und n liegt, aufweist:
o eine positive Versorgungsklemme (111 bis 114), die mit dem Eingang (11) der positiven Versorgungsspannung V_{CC} verbunden ist,
o eine negative Versorgungsklemme (121 bis 124), die mit dem Eingang (12) der negativen Versorgungsspannung V_{EE} verbunden ist,
o eine nicht invertierende Signaleingangsklemme, Viₚₗᵤₛ (131 bis 134) genannt, die mit dem Eingang (13) des Signals Vₚₗᵤₛ verbunden ist, so dass die Signale Viₚₗᵤₛ für die n Betriebsverstärker identisch sind,
o eine invertierende Signaleingangsklemme, Viₘᵢₙᵤₛ (141 bis 144) genannt, die mit dem Eingang (14) des Signals Vₘᵢₙᵤₛ verbunden ist, so dass die Signale Viₘᵢₙᵤₛ für die n Betriebsverstärker identisch sind,
o eine Ausgangsklemme des verstärkten Signals, Viₒᵤₜ (151 bis 154) genannt, mit einer Spannung zwischen den Versorgungsspannungen V_{CC} und V_{EE}, die sich aus der Verstärkung der Differenz der beiden Spannungen der Eingangssignale Viₚₗᵤₛ und Viₘᵢₙᵤₛ gemäß einer identischen vorbestimmten Verstärkung für die n Betriebsverstärker ergibt, und
o eine geschlossene dynamische Regelschleife, die die Klemme Viₒᵤₜ (151 bis 154) mit der Signaleingangsklemme Viₘᵢₙᵤₛ (141 bis 144) verbindet, eine Schleife, die aus mindestens einem elektrischen Widerstand (161 bis 164) und mindestens einem Kondensator (165 bis 168) besteht, die parallel geschaltet sind; und
- ein Elektronikmodul (17) zum Mitteln der Spannungen der verstärkten Ausgangssignale Viₒᵤₜ (151 bis 154) der n Betriebsverstärker (111 bis 114), um das verstärkte Signal Vₒᵤₜ am Ausgang des verstärkten Signals (15) zu erzeugen;
wobei der Proportional-Integral-Regler (30) auch eine geschlossene negative Rückkopplungsschleife (33, 34) enthält, die den Ausgang Vₒᵤₜ (15) mit dem Eingang Vₘᵢₙᵤₛ (14) verbindet und in Reihe geschaltet mindestens einen Kondensator (34) und mindestens einen elektrischen Widerstand (33) enthält; wobei der Eingang Vₘᵢₙᵤₛ über mindestens einen elektrischen Widerstand (32) ein elektrisches Signal empfängt und der Eingang Vₚₗᵤₛ (13) über mindestens einen elektrischen Widerstand (31) ein elektrisches Signal empfängt.

2. Proportional-Integral-Regler (30) nach Anspruch 1, für jeden Betriebsverstärker (101 bis 104) einen unabhängigen Entkopplungskreis (181 bis 184) zwischen dem Eingang der positiven Versorgungsspannung V_{CC} (11) und der positiven Versorgungsklemme (111 bis 114) dieses Betriebsverstärkers enthaltend.

3. Proportional-Integral-Regler (30) nach Anspruch 2, wobei der unabhängige Entkopplungskreis (181 bis 184) jedes Betriebsverstärkers (101 bis 104) enthält:
- mindestens einen elektrischen Widerstand (185) zwischen dem Eingang der positiven Versorgungsspannung V_{CC} (11) und der positiven Versorgungsklemme (111 bis 114) dieses Betriebsverstärkers, und
- mindestens einen Kondensator (186) zwischen dem Eingang der negativen Versorgungsspannung V_{EE} (12) und der positiven Versorgungsklemme (111 bis 114) dieses Betriebsverstärkers.

4. Proportional-Integral-Regler (30) nach einem der Ansprüche 1 bis 3, wobei für jeden Betriebsverstärker (101 bis 104):
- die nicht invertierende Klemme (131 bis 134) des Signaleingangs Viₚₗᵤₛ über mindestens einen elektrischen Widerstand (170), der für die n Betriebsverstärker identisch ist, mit dem Signaleingang (13) Vₚₗᵤₛ verbunden ist, und
- die invertierende Klemme (141 bis 144) des Signaleingangs Viₘᵢₙᵤₛ über mindestens einen elektrischen Widerstand (169), der für die n Betriebsverstärker identisch ist, mit dem Eingang (14) des Signals Vₘᵢₙᵤₛ verbunden ist.

5. Proportional-Integral-Regler (30) nach einem der Ansprüche 1 bis 4, wobei das Elektronikmodul (17) zum Mitteln der Spannungen der verstärkten Ausgangssignale Viₒᵤₜ der Betriebsverstärker zwischen jeder Ausgangsklemme der verstärkten Spannung Viₒᵤₜ (151 bis 154) eines Betriebsverstärkers (101 bis 104) und dem Ausgang der verstärkten Spannung (15) mindestens einen elektrischen Widerstand (171) enthält.

6. Proportional-Integral-Regler (30) nach einem der Ansprüche 1 bis 5, der in einer einzelnen integrierten Schaltung (20) enthält:
- die n Betriebsverstärker (101 bis 104),
- die n geschlossenen Regelschleifen (161 bis 168) der Dynamiksteuerung, die die Klemme Viₒᵤₜ (151 bis 154) mit der Eingangsklemme der Spannung Vₘᵢₙᵤₛ (141 bis 144) eines Betriebsverstärkers verbinden, und
- das Elektronikmodul (17) zum Mitteln der verstärkten Ausgangsspannungen Viₒᵤₜ der n Betriebsverstärker.

7. Geregelter Wandler (50, 60) vom Typ Gleichspannung/Gleichspannung, einen Proportional-Integral-Regler (30) nach einem der Ansprüche 1 bis 6 enthaltend, wobei die geschlossene negative Rückkopplungsschleife (33, 34), die den Ausgang Vₒᵤₜ (15) mit dem Eingang Vₘᵢₙᵤₛ (14) verbindet, in Reihe geschaltet, mindestens einen elektrischen Widerstand (33) und mindestens einen Kondensator (34) enthält.

8. Raumausrüstung (80), mindestens einen geregelten Wandler (50, 60) vom Typ Gleichspannung/Gleichspannung nach Anspruch 7 enthaltend.

## Claims

1. Integral proportional corrector (30) comprising an amplifier device (10), said amplifier device (10) comprising:
- a positive supply voltage input (11), voltage called "V_{CC}",
- a negative or "reference" supply voltage input (12), voltage called "V_{EE"},
- a non-inverting signal input (13), called "V_{plus"}, this signal having a voltage lying between the supply voltages V_{CC} and V_{EE},
- an inverting signal input (14), called "V_{minus"}, this signal having a voltage lying between the supply voltages V_{CC} and V_{EE},
- an amplified signal output (15), called "V_{out"},
- an integer n, strictly greater than 1, of operational amplifiers (101 to 104), each operational amplifier i, with i between 1 and n inclusive, having:
o a positive supply terminal (111 to 114) connected to the positive supply voltage input (11) V_{CC},
o a negative supply terminal (121 to 124) connected to the negative supply voltage input (12) V_{EE},
o a non-inverting signal input terminal, called Viₚₗᵤₛ (131 to 134) connected to the signal input Vₚₗᵤₛ (13), such that the signals Viₚₗᵤₛ are identical for the n operational amplifiers,
o an inverting signal input terminal, called Viₘᵢₙᵤₛ (141 to 144) connected to the signal input Vₘᵢₙᵤₛ (14), such that the signals Viₘᵢₙᵤₛ are identical for the n operational amplifiers,
o an amplified signal output terminal, called Viₒᵤₜ (151 to 154) with a voltage lying between the supply voltages V_{CC} and V_{EE}, resulting from the amplification of the difference of the two voltages of the input signals Viₚₗᵤₛ and Viₘᵢₙᵤₛ according to an identical predetermined gain for the n operational amplifiers, and
o a dynamic-control closed loop connecting the terminal Viₒᵤₜ (151 to 154) to the signal input terminal Viₘᵢₙᵤₛ (141 to 144), a loop consisting of at least one electrical resistor (161 to 164) and at least one capacitor (165 to 168), connected in parallel; and
- an electronic module (17) for averaging the voltages of the amplified output signals Viₒᵤₜ (151 to 154) of the n operational amplifiers (111 to 114), to generate the amplified signal Vₒᵤₜ on the amplified signal output (15);
the integral proportional corrector (30) also comprising a negative feedback closed loop (33, 34) connecting the output Vₒᵤₜ (15) to the input Vₘᵢₙᵤₛ (14) and including in series at least one capacitor (34) and at least one electrical resistor (33); the input Vₘᵢₙᵤₛ receiving an electrical signal via at least one electrical resistor (32), and the positive input Vₚₗᵤₛ (13) receiving an electrical signal via at least one electrical resistor (31).

2. Integral proportional corrector (30) according to claim 1, which comprises, for each operational amplifier (101 to 104), an independent decoupling circuit (181 to 184), between the positive supply voltage input V_{CC} (11) and the positive supply terminal (111 to 114) of this operational amplifier.

3. Integral proportional corrector (30) according to claim 2, wherein the independent decoupling circuit (181 to 184) of each operational amplifier (101 to 104) comprises:
- at least one electrical resistor (185) between the positive supply voltage input V_{CC} (11) and the positive supply terminal (111 to 114) of this operational amplifier, and
- at least one capacitor (186) between the negative supply voltage input V_{EE} (12) and the positive supply terminal (111 to 114) of this operational amplifier.

4. Integral proportional corrector (30) according to any one of claims 1 to 3, wherein, for each operational amplifier (101 to 104):
- the non-inverting signal input terminal (131 to 134) Viₚₗᵤₛ is connected to the signal input (13) Vₚₗᵤₛ, via at least one identical electrical resistor (170) for the n operational amplifiers, and
- the inverting signal input terminal (141 to 144) Viₘᵢₙᵤₛ is connected to the signal input (14) Vₘᵢₙᵤₛ, via at least one identical electrical resistor (169) for the n operational amplifiers.

5. Integral proportional corrector (30) according to one of claims 1 to 4, wherein the electronic module (17) for averaging the amplified output voltages Viₒᵤₜ of the operational amplifiers comprises, between each amplified voltage output terminal Viₒᵤₜ (151 to 154) of an operational amplifier (101 to 104) and the amplified voltage output (15), at least one electrical resistor (171).

6. Integral proportional corrector (30) according to one of claims 1 to 5, which comprises, in a single integrated circuit (20):
- the n operational amplifiers (101 to 104),
- the n dynamic-control closed loops (161 to 168) connecting the terminal Viₒᵤₜ (151 to 154) to the voltage input terminal Vₘᵢₙᵤₛ (141 to 144) of an operational amplifier, and
- the electronic module (17) for averaging the amplified output voltages Viₒᵤₜ of the n operational amplifiers.

7. Regulated converter (50, 60) of the direct voltage/direct voltage type which comprises an integral proportional corrector (30) according to any one of claims 1 to 6, wherein the negative-feedback closed loop (33, 34) connecting the output Vₒᵤₜ (15) to the input Vₘᵢₙᵤₛ (14) comprises, in series, at least one electrical resistor (33) and at least one capacitor (34).

8. Space equipment (80) comprising at least one converter (50, 60) of the regulated direct voltage/direct voltage type according to claim 7.
